# EUROPEAN PATENT APPLICATION

(11) **EP 2 475 094 A1**
(43) Date of publication of application: **11.07.2012**
(21) Application number: 11360001.9
(22) Date of filing: 07.01.2011
(51) Int. Cl.: H03F 1/02, H03F 1/32, H03F 3/24

(54) **Doherty amplifier**

(71) Applicant: Alcatel Lucent, 75007 Paris (FR)
(72) Inventor: Wong, James N. H., London W3 0HW (GB)
(74) Representative: Coghlan, Judith Elizabeth Kensy

(57) **Abstract**

A Doherty amplifier operable to amplify a source signal, comprises a main amplifier module (30), at least one auxiliary amplifier module (60) and a source signal processing unit (200). Each amplifier module (30,60) is switchable between an amplifying state and a non-amplifying state to vary a power of an amplified output signal provided by the Doherty amplifier. The source signal processing unit (200) is operable to receive the source signal and provide the main amplifier (30) with a first processed signal and the auxiliary amplifier (60) with a second processed signal. The first and second processed signals are processed from the source signal and each of the first and second processed signals are independently adjustable by the source signal processing unit. Such an arrangement allows a greater degree of freedom when choosing analogue components for the manufacture of a Doherty amplifier.

## Description

### FIELD OF THE INVENTION

The present invention relates to a Doherty amplifier.

### BACKGROUND

Doherty amplifiers are known. In most communications systems, it is required that power amplifiers used to amplify signals for transmissions are able to operate with high efficiency and high linearity simultaneously. However, there is typically a trade-off between efficiency and linearity, with improvements in one generally coming at the expense of the other. Many wireless telecommunications systems, such as a Global System for Mobile communications (GSM)/Enhanced Data rates for GSM Evolution (EDGE), Code Division Multiple Access (CDMA) or Wideband Code Division Multiple Access (WCDMA) require that the power amplifier is able to deliver a wide range of output powers.

Accordingly, the power amplifiers are typically designed to provide the highest power output level with the maximum available efficiency. These amplifiers, which may be provided in base stations, tend to operate less efficiently at lower power levels. Designing a base station power amplifier which has a high efficiency and high linearity, not only at the maximum output power but also at lower output power levels, typically ranging from -6dB and less, without using additional linearization schemes, is challenging. A Doherty power amplifier is one such power amplifier in which a main amplifier is provided in parallel with an auxiliary amplifier. The input signal is split and provided to each of the amplifiers. Both of the amplifiers then amplify the signal, which is then combined to create an output signal. When operating at the maximum power output, both amplifiers are used. However, when the total output power is typically less than 6dB from the maximum output power, the auxiliary amplifier is turned off. This arrangements provides higher efficiency compared to conventional Class AB solutions, since the main amplifier is biased in Class AB, but the auxiliary amplifier is biased in Class C and is turned off when the total output power is typically less than 6dB from the maximum output power level. Although these arrangements provide for higher efficiency at other than the maximum output power level, such parallel amplifiers exhibit undesirable characteristics.

Accordingly, it is desired to provide an improved Doherty amplifier.

### SUMMARY

Accordingly, a first aspect provides a Doherty amplifier operable to amplify a source signal, comprising: a main amplifier module, at least one auxiliary amplifier module, each module being switchable between an amplifying state and a non-amplifying state to vary a power of an amplified output signal provided by said Doherty amplifier; and a source signal processing unit operable to receive said source signal to provide said main amplifier with a first processed signal and said auxiliary amplifier with a second processed signal, said first and second processed signals being processed from said source signal and each of said first and second processed signals being independently adjustable by said source signal processing unit.

The first aspect recognises that a typical Doherty amplified comprises a main amplifying stage and one or more auxiliary amplifying stages. The number of amplifying stages that are in the amplifying state varies in dependence on the power output required from the Doherty amplified. When less power is required to be output by the Doherty amplifier, then one or more of the auxiliary amplifying stages will be switched off.

Each amplifying stage amplifies the input signal in parallel and the amplified output of each of the amplifying stages are then combined to provide an amplified output signal. Accordingly, typically an input network is provided which feeds the signal to the amplified in parallel to each of the amplifying stages. Also, an output network is provided which receives each amplified output signal and combines these to provide an amplified output to a load.

Typically the input network provides necessary phase shifts to the input signals being fed to each of the amplifier stages. Likewise, the output network provides the necessary phase shift prior to combining the output signals provided by each of the amplifying stages. The characteristics of the input and output networks are usually carefully selected to provide both the required phase shifts and provide impedance matching in order to maximise power transfer into a load.

The first aspect recognises that as the demand for data rates in wireless telecommunication systems has increased there has become a demand for amplifiers to operate more efficiently. In order to ensure efficient optimised operation of a Doherty amplifier it has traditionally been necessary to very carefully select analogue component parts to be used in that Doherty amplifier to minimise phase difference delays induced between the main amplifying stage and auxiliary stages such that when combined, the amplified signals from each stage provide an appropriately amplified combined signal to a load.

Demand for higher efficiency and linearity performance from amplifiers has significantly increased. Current active device technologies such as, for example, laterally diffused metal oxide semiconductor components (LDMOS) are reaching their maximum performance potentials in terms of use within a Doherty amplifier architecture.

Although it is possible to achieve a higher efficiency Doherty amplifier by using gallium nitride components (GaN) devices, those devices come at significant cost.

Existing amplifier architectures used in remote radio heads are typically based on Doherty architecture. Those known amplifier architectures can be symmetrical, meaning that in each amplifier stage an identically sized device is provided, or asymmetrical, meaning that differently sized devices are provided in the main and auxiliary amplified stages. An asymmetrical architecture may offer improved proficiency performance at a greater output back off power level (greater than 6 dB) whereas a symmetrical architecture typically has optimum efficiency performance at 6 dB output back off.

In such known architectures, it is common to find that the Doherty amplifiers are manufactured using devices having the same technology from the same manufacturer. For example an LDMOS based Doherty or a GaN based Doherty. High voltage hetrojunction bipolar transistors may also be used in a Doherty amplifier architecture. LDMOS based Doherty designs are nearing the maximum performance potential and can no longer offer any further improvements in efficiency performance.

Gallium nitride and high voltage hetrojunction bipolar transistor based Doherty amplifiers may offer additional efficiency gains but such efficiency gains come with a high cost impact.

A wireless telecommunications network is ideally operable to deliver technologically competitive and relatively low cost remote radio head (RRH) products and thus the first aspect recognises that it is possible to address issues resulting from choice of component parts of a Doherty amplifier without simply requiring more expensive component parts. By providing a source signal processing unit which can independently adjust a signal to be fed into a main and auxiliary amplifier module, it becomes possible to provide a Doherty amplifier which provides improved efficient performance whilst not costing significantly more in terms of analogue component parts having a high efficiency, and selected carefully in order to provide a suitable overall amplifier performance.

The first aspect particularly recognises that by independently driving each of the signals feeding the main and auxiliary amplifier stages it is possible to no longer focus attention so tightly on perfectly matched analogue components and instead compensate for differences in the components forming the main and auxiliary amplifier stages by feeding different pre-processed signals to each of the amplifier stages. As a result the construction and manufacture stages of creation of a Doherty amplifier become less critical to overall efficiency achieved by the resulting amplifier.

Independently driving each of the amplifier stages can allow for a significant increase in production yield such that Doherty amplifiers created in accordance with the first aspect can offer a particularly high production yield. Imbalances resulting from component parts can be compensated for by appropriate processing of each signal driving each amplifying stage.

In one embodiment, the first and second processed signals are different. Accordingly, it will be appreciated that in some architectures, the components may be such that the signals used to drive each of the amplifier stages may be substantially identical. However, even if the component parts of the main-and auxiliary amplifiers stages in accordance with the first aspect are identical, it can be possible to adjust the processed signals input into each stage such that the resulting output is optimised allowing for any small structural differences between amplifier stages. Such independent driving of amplifier stages allows for improved operation of a resulting Doherty amplifier.

In one embodiment, the source signal-processing unit is operable to adjust a relative phase difference between the first and second processed signal. It will be appreciated that if the main and auxiliary amplifier stages are not perfectly matched, a phase difference delay is introduced to the signals processed by each of the stages such that when signals passing through each amplifier stage are combined, a nominal power output which is to be achieved by the Doherty amplifier may not be met. Accordingly it is possible to process the input signals being fed to each amplifier stage, in accordance with appropriate algorithms, such that the output of the Doherty amplifier meets that nominal power output.

In one embodiment, the source signal-processing unit is operable to adjust a phase of at least one of said first and second processed signals. By allowing control of the phase of at least one of the first and second processed signals the relative phase difference between the first and second processed signal may be altered by very fine amounts to ensure that a nominal power output is met. In a typical Doherty amplifier architecture, the phase of a signal being fed to the main amplifier is held constant whilst the phase of a signal being fed to an auxiliary amplifier may be shifted through 90°. It will be appreciated that by allowing for adjustment of a relative phase difference between the first and second processed signal either the first or second processed signal may be altered thereby allowing for a change in relative phase difference between those signals.

In one embodiment, the source signal-processing unit is operable to introduce a net phase shift of substantially a quarter wavelength between the first and second processed signals. Accordingly, rather than rely on analogue components to introduce an appropriate phase shift between a signal being fed to a main and auxiliary amplifier stage, it is possible to introduce that phase shift of 90° by processing the input signal to one or other, or both, of the first and second processed signals.

In one embodiment, the source signal processing unit is operable to adjust an amplitude of at least one of said first and second processed signals. Accordingly, by changing the amplitude of processed signal 1 and processed signal 2 independently, it is possible that when those signals are combined to create an amplified reconstructed combined signal that the frequency distortion introduced into the amplified signal is minimised. Such an approach ensures that the signal produced by the Doherty amplifier remains within a radio channel of interest.

According to a traditional analogue approach, it is possible to use digital predistortion to ameliorate problems in Doherty amplifiers associated with frequency distortion. The digital predistortion is typically applied to a signal before it is split and an identically pre-distorted signal is fed to all amplifier stages. Such an analogue approach does not allow much freedom to control the signal exiting the Doherty amplifier. Allowing for independent adjustment of process signals entering each stage allows the amplifier to operate in such a way that it is dynamically adaptable and there is less stress applied to the signal in digital predistortion.

In one embodiment, the source signal processing unit is operable to adjust said first and second processed signals such that an amplitude of the first and second processed signals is substantially identical. Accordingly, the operation of the Doherty amplifier in accordance with a first aspect may be adjusted such that, even when not operating at peak power, the amplifier may still offer good efficiency returns to a signal being amplified.

In one embodiment, the source signal processing unit is operable to modify an amplitude of at least one of the first and second processed signals independently from an amplitude of the other of said first and second processed signals. Accordingly, effective efficient operation of a Doherty amplifier in accordance with the first aspect may be achieved.

In one embodiment, the source signal processing unit is operable to modify a phase of at least one of the first and second processed signals independently from a phase of the other of the first and second processed signals. Accordingly, the nominal power output of the Doherty amplifier may be optimised.

In one embodiment, the Doherty amplifier further comprises an output monitoring device operable to measure characteristics of the amplified output signal provided by the Doherty amplifier and feed information relating to the measured output signal characteristics to the signal processing unit. Accordingly, by providing an output monitoring device it is possible that adjustment to the first and second processed signals may be made dynamically such that the Doherty amplifier continues to operate efficiently.

In one embodiment, the signal processing unit is operable to adjust the first and second processed signals in response to the information relating to the measured characteristics. Such an arrangement allows use of appropriate algorithms within the signal processing unit to ensure that the desired output characteristics of the Doherty amplifier are maintained.

In one embodiment, the main amplifier module and the auxiliary amplifier module comprised match transistor devices. Accordingly, differences between those matched devices may be accounted for by appropriate pre-processing of the processed signals being fed to the main and auxiliary amplifier stages.

In one embodiment, the main amplifier module comprises a high efficiency transistor device. Accordingly, by providing a high efficiency high performance device as the main half of a Doherty amplifier and a relatively low cost device in an auxiliary stage of the same Doherty amplifier, the efficiency of the main device may be fully utilised and the group delays introduced by the use of two such different technologies can be accounted for in the input of such a hybrid Doherty amplifier by driving those stages separately instead of driving them in parallel in the normal manner.

In one embodiment, the signal processing unit is operable to adjust the first and second processed signal in the digital domain. Use of digital modulation schemes has evolved over the years and allows the signals being fed into a Doherty amplifier to be significantly processed and removes the need to carefully match Doherty amplifier components in the analogue domain.

It will be appreciated that the first aspect allows a main amplifying device provided within a Doherty amplifier to be a better performing transistor technology such as a gallium nitride or HVHBT device. LDMOS technology may be used for the auxiliary device of the same Doherty amplifier. Such a combination, using different transistor technology, leads to the concept of a hybrid Doherty.

Due to the demand for higher data rates for telecommunications, digital modulation schemes have evolved over the years, with W-CDMA being the most commonly used modulation scheme as the industry prepares for the next generation LTE scheme. Clever crest factor reduction (CFR) techniques have enabled the nominally high output power peak to average ratios (PAR) to be reduced to levels closer to 6dB without impacting an error vector magnitude (EVM) of a signal. In a classic symmetrical Doherty amplifier, such crest factor reduction signals allows the amplifier to be operating perfectly at a 6dB output back off region at its best efficiency peak.

The first aspect allows use of a high performance device as the main half of a Doherty amplifier and a relatively low cost DLD MOS device within the auxiliary half of the same Doherty amplifier. In order to solve the group delays between such technologies, the input of such a hybrid Doherty amplifier is driven separately instead of being driven through a quadrature hybrid 3DB splitter such as those used in classic Doherty amplifiers.

According to a second aspect, there is provided a method of providing a Doherty amplifier operable to amplify a source signal, said method comprising the steps of: providing a main amplifier module and at least one auxiliary amplifier module, each module being operable to receive an input signal and being switchable between an amplifying state and a non-amplifying state to vary a power of an amplified output signal provided by said Doherty amplifier; and providing a source signal processing unit operable to receive said source signal to provide said main amplifier with a first processed signal and said auxiliary amplifier with a second processed signal, said first and second processed signals being processed from said source signal and each of said first and second processed signals being independently adjustable by said source signal processing unit.

In one embodiment, the first and second processed signals are different.

In one embodiment, the source signal processing unit is operable to adjust a relative phase difference between the first and second processed signal.

In one embodiment, the source signal processing unit is operable to adjust a phase of at least one of the first and second processed signals.

In one embodiment, the source signal processing unit is operable to introduce a net phase shift of substantially a quarter wavelength between the first and second processed signals.

In one embodiment, the source signal processing unit is operable to adjust an amplitude of at least one of the first and second processed signals.

In one embodiment, the source signal processing unit is operable to adjust the first and second processed signals such that an amplitude of the first and second processed signals is substantially identical.

In one embodiment, the source signal processing unit is operable to modify an amplitude of at least one of the first and second processed signals independently from an amplitude of the other of the first and second processed signals.

In one embodiment, the source signal processing unit is operable to modify a phase of at least one of the first and second processed signals independently from a phase of the other of the first and second processed signals.

In one embodiment, said method further comprises the step of providing an output monitoring device operable to measure characteristics of the amplified output signal provided by the Doherty amplifier and feed information relating to the measured output signal characteristics to the signal processing unit.

In one embodiment, the signal processing unit is operable to adjust the first and second processed signals in response to the information relating to the measured characteristics.

In one embodiment, the main amplifier module and the auxiliary amplifier module comprise matched transistor devices.

In one embodiment, the main amplifier module comprises a high efficiency transistor device.

In one embodiment, the signal processing unit is operable to adjust the first and second processed signal in a digital domain.

Further particular and preferred aspects of the present invention are set out in the accompanying independent and dependent claims. Features of the dependent claims may be combined with features of the independent claims as appropriate, and in combinations other than those explicitly set out in the claims.

### BRIEF DESCRIPTION OF THE DRAWINGS

Embodiments of the present invention will now be described further, with reference to the accompanying drawings in which:
Figure 1a illustrates schematically a classic Doherty amplifier;
Figure 1b illustrates the typical performance of a classic Doherty amplifier using laterally diffused metal oxide semiconductor technology;
Figure 2a illustrates schematically a hybrid Doherty amplifier; and
Figure 2b illustrates the performance of a digital hybrid Doherty amplifier such as that shown schematically in Figure 2a.

### DESCRIPTION OF THE EMBODIMENTS

Before discussing the embodiments in any detail, an overview of the operation of a Doherty amplifier according to embodiments will now be described.

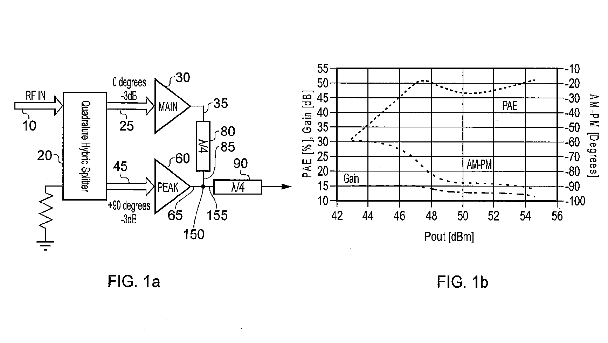

Figure 1a illustrates schematically a typical Doherty amplifier comprising a main amplifying stage and one auxiliary amplifying stage. The number of amplifying stages that are in the amplifying state varies in dependence on the power output required from the Doherty amplifier. When less power is required to be output by the Doherty amplifier then one or more of the auxiliary amplifying stages will be switched off. Each amplifying stage amplifies the input signal in parallel and the amplified outputs of each of the amplifying stages are then combined to provide the amplified output signal. Accordingly, an input network is provided which feeds the signal to be amplified in parallel to each of the amplifying stages. Also, an output network is provided which receives each amplified output signal and combines these to provide an amplified output to a load. The input network provides the necessary phase shifts to the input signals being fed to each of the amplifier stages. Likewise, the output network provides the necessary phase shift prior to combining the output signals provided by each of the amplifying stages. The characteristics of the input and output networks are carefully selected to provide both the required phase shifts and to provide impedance matching in order to maximise the power transfer into the load.

The RF signal 10 to be amplified is received at the signal splitter 20. The signal splitter 20 divides the signal into two and outputs the signals at points A and B. It will be appreciated that such signal splitters are well known in the art. The split signal is provided over the line 25 to a main amplifying stage 30. A quarter wavelength delayed signal is provided over the line 45 to the first auxiliary stage 60. Typically, for design convenience and general interoperability, the characteristic impedance of the line over which the RF signal 10 is received, together with the characteristic impedances of the splitter and the lines together with the delay lines, will each be 50 ohms. However, it will be appreciated that other characteristic impedances could be selected depending on the particular application.

Each of the amplifier stages 30, 60 have an input impedance matching circuit and an output impedance matching circuit, together with a main amplifying device. In this example, the impedance matching circuits configure the amplifying devices to present a 50 ohms input impedance and a 50 ohms output impedance. However, once again, it will be appreciated that the impedance matching circuits may be configured to provide other input and output impedances. Also, in this example, the power outputs of the main and first auxiliary stages are matched; but the power output of the auxiliary stage need not be matched. It will be appreciated that this provides significant flexibility to select different devices best suited to the needs of the Doherty amplifier.

The amplified output of the main stage is provided over the line 35 to the quarter wavelength transformer 80. The amplified output signal from the main device is provided to over the line 85 to a summing point 150 where it is combined with the amplified output signal received from the first auxiliary stage over the line 65. The combined signal is then received over the line 155 at a quarter wavelength transformer 90. The combined signal from the two amplifier stages is provided via the quarter wave transformer 90 to a load (not shown).

The Doherty amplifier shown in Figure 1 a utilises a quadrature hybrid splitter to provide a substantially identical drive signal to each of the main amplifier 30 and the peak amplifier 60, with the signal provided to the peak amplifier being fixedly phase shifted by +90 degrees, that fixed phase shift being introduced by the hybrid splitter.

Figure 1b illustrates the performance characteristics of a Doherty amplifier such as that shown in Figure 1a using matched LDMOS technology components for each of the main and peak amplifier stages.

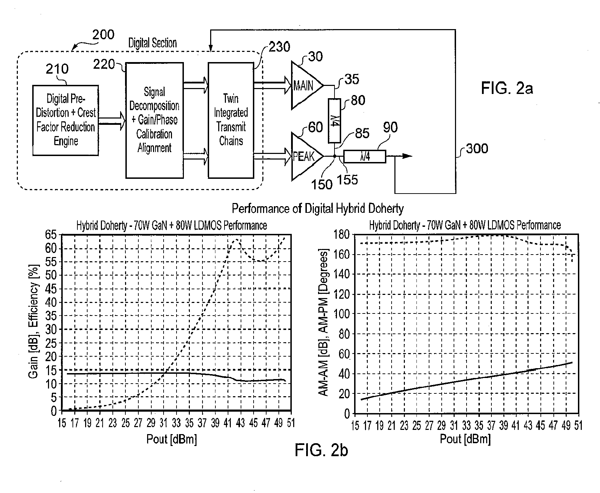

Figure 2a illustrates schematically a hybrid Doherty amplifier in accordance with one embodiment of the first aspect. The general architecture of a classic Doherty amplifier is maintained and identical reference numerals have been used throughout Figure 2a accordingly. However, the quadrature hybrid splitter 20 used in the example shown in Figure 1 a has been replaced by a digital processing until 200. That digital processing unit comprises a digital predistortion and crest factor reduction engine 210 which is operable to communicate with a signal decomposition and gain/phase calibration alignment processor 220 which itself is operable to provide two processed signals to twin integrated transmit chains 230. Those independently created signals are fed to the main amplifier 30 and peak amplifier 60 as before. In the embodiment shown in Figure 2a, a feedback loop 300 is provided such that the output provided by the Doherty amplifier illustrated in Figure 2a is fed back to digital processing unit 200 and the signal decomposition and gain and phase calibration alignment logic 220 is operable to dynamically adjust the signals being sent via transmit chains 230 to each of the main and peak amplifying stages to optimise the output being fed to a load (not shown). It will be understood that appropriate algorithms to be implemented by digital processing until 200 in response to feedback loop 300 will be apparent to those skilled in the art.

It will thus be appreciated that the architecture illustrated in Figure 2a enables a hybrid Doherty amplifier to be provided which does not require perfectly matched analogue components to be used in the main or peak amplifying stage or impedance matching networks, since variations in components can be accounted for by pre-processing input signals independent upon a signal output from the Doherty amplifier. This enables devices to be easily selected for full performance and cost optimisation and enables the design of a cost effective Doherty to be significantly simplified.

Figure 2b illustrates the performance of additional hybrid Doherty such as that shown schematically in Figure 2a.

A person of skill in the art would readily recognize that steps of various above-described methods can be performed by programmed computers. Herein, some embodiments are also intended to cover program storage devices, e.g., digital data storage media, which are machine or computer readable and encode machine-executable or computer-executable programs of instructions, wherein said instructions perform some or all of the steps of said above-described methods. The program storage devices may be, e.g., digital memories, magnetic storage media such as a magnetic disks and magnetic tapes, hard drives, or optically readable digital data storage media. The embodiments are also intended to cover computers programmed to perform said steps of the above-described methods.

The functions of the various elements shown in the Figures, including any functional blocks labelled as "processors" or "logic", may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" or "logic" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non volatile storage. Other hardware, conventional and/or custom, may also be included. Similarly, any switches shown in the Figures are conceptual only. Their function may be carried out through the operation of program logic, through dedicated logic, through the interaction of program control and dedicated logic, or even manually, the particular technique being selectable by the implementer as more specifically understood from the context.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

## Claims

1. A Doherty amplifier operable to amplify a source signal, comprising:
a main amplifier module,
at least one auxiliary amplifier module, each module being switchable between an amplifying state and a non-amplifying state to vary a power of an amplified output signal provided by said Doherty amplifier; and
a source signal processing unit operable to receive said source signal to provide said main amplifier with a first processed signal and said auxiliary amplifier with a second processed signal, said first and second processed signals being processed from said source signal and each of said first and second processed signals being independently adjustable by said source signal processing unit.

2. A Doherty amplifier according to claim 1, wherein said first and second processed signals are different.

3. A Doherty amplifier according to claim 1 or claim 2, wherein said source signal processing unit is operable to adjust a relative phase difference between said first and second processed signal.

4. A Doherty amplifier according to any one of claims 1 to 3, wherein said source signal processing unit is operable to adjust a phase of at least one of said first and second processed signals.

5. A Doherty amplifier according to any preceding claim, wherein said source signal processing unit is operable to introduce a net phase shift of substantially a quarter wavelength between said first and second processed signals.

6. A Doherty amplifier according to any preceding claim, wherein said source signal processing unit is operable to adjust an amplitude of at least one of said first and second processed signals.

7. A Doherty amplifier according to any preceding claim, wherein said source signal processing unit is operable to adjust said first and second processed signals such that an amplitude of said first and second processed signals is substantially identical. l.

8. A Doherty amplifier according to any preceding claim, wherein said source signal processing unit is operable to modify an amplitude of at least one of said first and second processed signals independently from an amplitude of said other of said first and second processed signals.

9. A Doherty amplifier according to any preceding claim, wherein said source signal processing unit is operable to modify a phase of at least one of said first and second processed signals independently from a phase of said other of said first and second processed signals.

10. A Doherty amplifier according to any preceding claim, further comprising an output monitoring device operable to measure characteristics of said amplified output signal provided by said Doherty amplifier and feed information relating to said measured output signal characteristics to said signal processing unit.

11. A Doherty amplifier according to claim 10, wherein said signal processing unit is operable to adjust said first and second processed signals in response to said information relating to said measured characteristics.

12. A Doherty amplifier according to any preceding claim, wherein said main amplifier module and said auxiliary amplifier module comprise matched transistor devices.

13. A Doherty amplifier according to any preceding claim, wherein said main amplifier module comprises a high efficiency transistor device.

14. A Doherty amplifier according to any preceding claim, wherein said signal processing unit is operable to adjust said first and second processed signal in a digital domain.

15. A method of providing a Doherty amplifier operable to amplify a source signal, said method comprising the steps of:
providing a main amplifier module and at least one auxiliary amplifier module, each module being operable to receive an input signal and being switchable between an amplifying state and a non-amplifying state to vary a power of an amplified output signal provided by said Doherty amplifier; and
providing a source signal processing unit operable to receive said source signal to provide said main amplifier with a first processed signal and said auxiliary amplifier with a second processed signal, said first and second processed signals being processed from said source signal and each of said first and second processed signals being independently adjustable by said source signal processing unit.
